# EUROPEAN PATENT SPECIFICATION

(11) **EP 3 077 567 B1**
(45) Date of publication and mention of the grant of the patent: **24.02.2021**
(21) Application number: 13814860.6
(22) Date of filing: 06.12.2013
(51) Int. Cl.: C23C 14/14, C23C 14/24, C23C 14/54, B01D 1/00

(54) **DEPOSITING ARRANGEMENT, DEPOSITION APPARATUS AND METHODS OF OPERATION THEREOF**
VERDAMPFUNGSANORDNUNG, ABSCHEIDUNGSVORRICHTUNG UND VERFAHREN ZUM BETRIEB DAVON
AGENCEMENT DE DÉPÔT, APPAREIL DE DÉPÔT ET LEURS PROCÉDÉS DE FONCTIONNEMENT

(43) Date of publication of application: 12.10.2016
(73) Proprietor: Applied Materials, Inc., Santa Clara, CA 95054 (US)
(72) Inventor: SCHÜßLER, Uwe, 63743 Aschaffenburg (DE); BANGERT, Stefan, 36396 Steinau (DE); KEIM, Karl-Albert, 63654 Büdingen (DE); DIEGUEZ-CAMPO, Jose Manuel, 63457 Hanau (DE)
(74) Representative: Zimmermann & Partner Patentanwälte mbB
(86) International application number: PCT/EP2013/075850
(87) International publication number: WO 2015/082022

(56) References cited:
- WO-A1-2013/143692
- JP-A- H02 118 064
- US-A- 2 664 852
- US-A- 5 135 817
- US-A- 5 492 724
- US-A1- 2011 308 453
- YADIN E: "DEPOSITION OF COATINGS OR FREE FOILS OF SUBLIMATING METALS", ANNUAL TECHNICAL CONFERENCE PROCEEDINGS SOCIETY OF VACUUM COATERS, ALBUQUERQUE, NM, US, 12 April 1997 (1997-04-12), pages 390-394, XP009052160,

## Description

### FIELD

Embodiments of the present disclosure relate to deposition and evaporation of alkali metals or alkaline earth metals, such as lithium. Embodiments of the present disclosure particularly relate to evaporation arrangements, deposition apparatuses, and methods of operation thereof for control of vaporized material. Specifically, they relate to a depositing arrangement for evaporation of a material comprising an alkali metal or alkaline earth metal and for deposition of the material on a substrate, a deposition apparatus for evaporation of a material comprising an alkali metal or alkaline earth metal and for deposition of the material on a substrate, and a method of evaporating a material comprising an alkali metal or alkaline earth metal, particularly metallic lithium.

### BACKGROUND

Modern thin film lithium batteries are, as a rule, produced in a vacuum chamber, wherein a substrate is provided with several layers, including a lithium layer. The lithium layer is formed, for example, through the deposition of lithium in a vapor state on the substrate. Since lithium is highly reactive, a plurality of measures needs to be addressed to operate and maintain such deposition systems. For example, exposure to air ambient's oxidizing vapors, in particular H₂O, and contact with personnel after opening the vacuum chamber should be minimized.

Further, vaporization with high deposition rates and increased uniformity is desired. Many types of thin film deposition systems have been deployed in the past. And, for alkali and/or alkaline earth metals, some typical arrangements of thin film deposition systems have been applied. However, these typical arrangements are not so amenable to high volume and low cost manufacturing because the methods have serious challenges in managing the high reactivity of the materials, while scaling to high volume production. This presents serious challenges in producing uniformly deposited pure lithium. As is well known, these types of materials, especially lithium, can easily be oxidized in reaction with ambient surroundings, e.g., gases, materials, etc. Thereby, lithium is of particular interest since it is suitable for the production of higher energy density batteries and accumulators.

Common deposition systems for lithium, and other alkali metals or alkaline earth metals, respectively, utilize sputtering sources or conventional evaporation sources and methods of operating thereof. Sputtering methods for lithium are challenging, particular with respect to costs and manufacturability, in light of the reactivity of lithium. The high reactivity at first influences the manufacturing of the target, which is a necessary component for sputtering, and secondly influences the handling of the resulting targets. Thereby, shipment, installation, preventive maintenance, etc., is more difficult as compared to non-reactive targets as the target material needs to be protected from reaction with ambient air. Another challenge comes from disposing of the spent material on the target as target utilization typically is not 100%. Accordingly, a user needs to neutralize or react the residual materials for safe disposal. Yet further and more importantly, since lithium's melting point is relatively low, at 183°C, the deposition rate can also be limited as the melting point limits against a high power density sputtering regime, a more amenable regime for high volume and lower cost manufacturing. In other words, the low melting point of lithium limits the maximal power which can be applied and therefore, the maximum deposition rate which can be achieved.

In conventional evaporation systems the liquid lithium flow is controlled by mechanically working valves. Because of the high reactivity of lithium it is difficult to avoid the formation of slug/particles (e.g., lithium oxides or hydroxides), which can block the valve and hinder an appropriate operation of these valves. Further, the parts of the valve which get into contact with the liquid lithium need to be made of stainless steel or molybdenum, which resists the liquid lithium at least for some time. However, no polymers or ceramics can be used, because lithium corrodes those materials.

In view of the above, new depositing arrangements, deposition apparatuses, and methods of operation thereof for control of vaporized material, that overcome at least some of the problems in the art are needed.
Yadin ("Deposition of coatings or free foils of sublimating metals", Annual Technical Conference Proceedings Society of Vacuum Coaters, 12 April 1997, pages 390-394) describes a magnesium vaporization source including a magnesium melting furnace, a heated liquid metal line for the metal supply into a vacuum chamber, and a tubular heated throttling vaporization element placed under a condensation zone. Liquid magnesium is fed into the vaporization element under pressure of argon.
WO 2013/143692 A1 describes an apparatus for feeding a metal to an evaporator device. The apparatus has a vessel for containing liquid metal from which through a feed tube liquid metal is fed to an evaporator device in a vacuum chamber. A supply line for an inert gas with a shut-off valve is provided to feed the gas under pressure to the vessel to pressurize the liquid metal in the vessel.
US 2 664 852 A describes a vapor coating apparatus. Aluminum is fed from a low-temperature zone to a high-temperature evaporation zone by gas pressure.
JP H02 118064 A describes a vacuum deposition device. Aluminum vaporized from a metal, such as molten A1 in a crucible in the vapor deposition chamber, is continuously deposited on a film.

US 5135817 B describes that Zn-Mg alloy is plated by vapor deposition on the surface of metals. Since Zn and Mg are vapor-deposited as a vapor mixture of an optional ratio on the surface of metals, plated layers of excellent corrosion resistance, peeling resistance of coating film, formability, etc., can be formed. A method of forming uniform vapor mixtures of Zn and Mg is disclosed, and vapor-depositing them on the surface of metals as the method forming the vapor-deposited layers.

### SUMMARY

In light of the above, a depositing arrangement, a deposition apparatus and a method of evaporating according to the independent claims are provided. Further aspects, advantages, and features of the present disclosure are apparent from the claims, the description, and the accompanying drawings.

According to one embodiment, a depositing arrangement for evaporation of a material comprising an alkali metal or alkaline earth metal and for deposition of the material on a substrate is provided. The depositing arrangement preferably includes a first chamber configured for liquefying the material, wherein the first chamber comprises a gas inlet configured for inlet of a gas in the first chamber, an evaporation zone configured for vaporizing the liquefied material, a line providing a fluid communication between the first chamber and the evaporation zone for the liquefied material, wherein the line includes a first portion defining a flow resistance of the line, a valve configured for controlling a flow rate of the gas in the first chamber for controlling a flow rate of the liquefied material through the line having said flow resistance, and one or more outlets for directing the vaporized material towards the substrate.

According to another embodiment, a deposition apparatus for evaporation of a material including an alkali metal or alkaline earth metal and for deposition of the material on a substrate is provided. The apparatus preferably includes a vacuum chamber for depositing the material on the substrate therein, and a depositing arrangement. The depositing arrangement includes a first chamber configured for liquefying the material, wherein the first chamber comprises a gas inlet configured for inlet of a gas in the first chamber, an evaporation zone configured for vaporizing the liquefied material, a line providing a fluid communication between the first chamber and the evaporation zone for the liquefied material, wherein the line includes a first portion defining a flow resistance of the line, a valve configured for controlling a flow rate of the gas in the first chamber for controlling a flow rate of the liquefied material through the line having said flow resistance, and one or more outlets for directing the vaporized material towards the substrate.

According to a further embodiment, a method of evaporating a material comprising an alkali metal or alkaline earth metal, particularly metallic lithium is provided. The method preferably includes liquefying the material in a first chamber, guiding the liquefied material from the first chamber through a line to an evaporation zone, wherein the line includes a first portion defining a flow resistance of the line, controlling a flow rate of a gas in the first chamber for controlling a flow rate of the liquefied material through the line having said flow resistance, evaporating the material in the evaporation zone, and directing the vapor of the material on a substrate.

### BRIEF DESCRIPTION OF THE DRAWINGS

So that the manner in which the above recited features of the present disclosure can be understood in detail, a more particular description of the disclosure, briefly summarized above, may be had by reference to embodiments. The accompanying drawings relate to embodiments of the disclosure and are described in the following:
- FIG. 1: shows a schematic view of a depositing arrangement for evaporation of alkali metals or alkaline earth metals, such as lithium, according to embodiments described herein;
- FIG. 2: shows a schematic view of another depositing arrangement for evaporation of alkali metals or alkaline earth metals, such as lithium, according to further embodiments described herein;
- FIG. 3: shows a schematic view of yet another depositing arrangement for evaporation of alkali metals or alkaline earth metals, such as lithium, according to further embodiments described herein;
- FIG. 4: shows a schematic view of a depositing arrangement and an apparatus for evaporation of alkaline metals or alkaline earth metals, such as lithium, according to yet further embodiments described herein;
- FIG. 5: shows a schematic view of yet another depositing arrangement and an apparatus for evaporation of alkali metals or alkaline earth metals, such as lithium, according to yet further embodiments described herein; and
- FIG. 6: shows a flow chart of an evaporation method according to embodiments described herein.

### DETAILED DESCRIPTION OF EMBODIMENTS

Reference will now be made in detail to the various embodiments of the disclosure, one or more examples of which are illustrated in the figures. Within the following description of the drawings, the same reference numbers refer to same components. Generally, only the differences with respect to individual embodiments are described. Each example is provided by way of explanation of the disclosure and is not meant as a limitation of the disclosure. Further, features illustrated or described as part of one embodiment can be used on or in conjunction with other embodiments to yield yet a further embodiment. It is intended that the description includes such modifications and variations.

Even though reference is sometimes made to lithium metal herein, it is understood that also other alkali or alkaline earth metals, which are highly reactive, can benefit from the arrangements described herein. Particularly alkali metals can be used, and the arrangements and apparatuses can be configured for alkali metals. Accordingly, also sodium, potassium, rubidium or cesium, can be evaporated for desired applications. Yet, utilization of and configuration for lithium is a typical embodiment. Lithium is even more reactive as compared to some other alkali or alkaline earth metals and can be used for a plurality of applications.

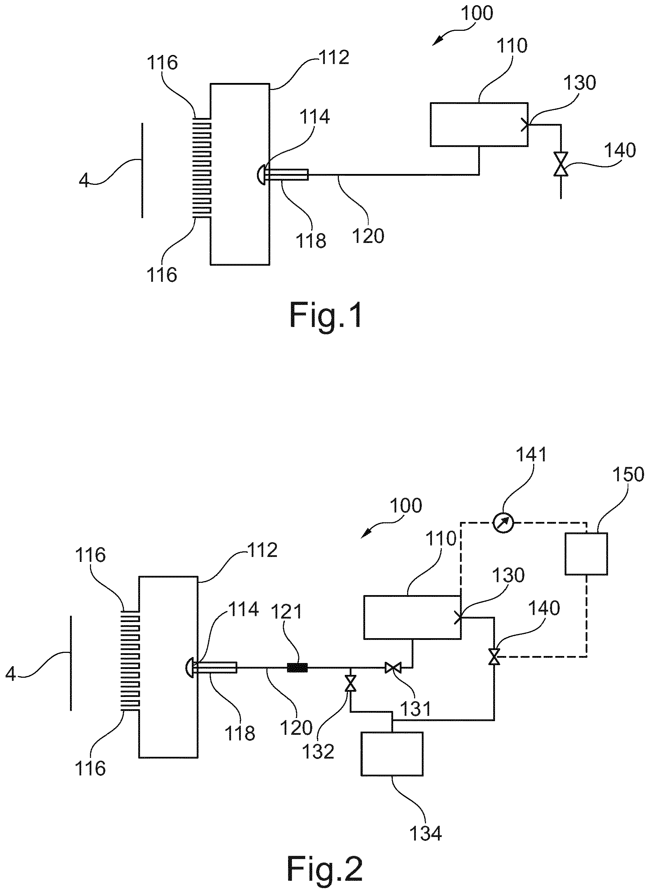

FIG. 1 shows a depositing arrangement 100 for evaporation of alkali and alkaline earth metals, particularly lithium. According to one embodiment, which could be combined with other embodiments described herein, the depositing arrangement 100 for evaporation of a material comprising an alkali metal or alkaline earth metal and for deposition of the material on a substrate 4 includes a first chamber 110 configured for liquefying the material, wherein the first chamber 110 comprises a gas inlet 130 configured for inlet of a gas in the first chamber 110. An evaporation zone 114 configured for vaporizing the liquefied material is provided. A line 120 providing a fluid communication between the first chamber 110 and the evaporation zone 114 for the liquefied material is provided, wherein the line includes a first portion defining a flow resistance of the line. A valve 140 is configured for controlling a flow rate of the gas in the first chamber 110 for controlling a flow rate of the liquefied material through the line 120 having said flow resistance, and one or more outlets 116 for directing the vaporized material towards the substrate 4.

The term "flow resistance" as used herein may define or affect a flow rate of the liquefied material through the line 120 in dependence on a pressure, and particularly a gas pressure in the first chamber 110. In other words, the flow rate of the liquefied material through the line 120 may depend on the flow resistance of the line 120 and the gas pressure in the first chamber 110. The flow resistance may be determined by at least one of a cross section area of the line 120, and particularly the first portion of the line 120, a temperature and a viscosity of the liquefied material.

According to some embodiments, the lithium evaporator includes two parts: First, a system placed at atmospheric pressure or another first pressure, which has a container in which the lithium is molten and a dosing mechanism to provide the needed molten lithium into the evaporation zone, which may be located in a vacuum chamber. Second, a vapor distribution system inside the vacuum chamber which distributes the lithium vapor on a substrate. Conventional systems use a mechanically working valve, which is prone to be blocked by particles. According to the embodiments described herein, this mechanically working valve is replaced by a line including a first portion, such as a capillary tube, an orifice or aperture, defining a flow resistance of the line. Deposition rate control is realized by applying a defined, controlled gas (e.g., argon) pressure in the container where the lithium is molten, and may be assisted or supported by the line having the defined flow resistance.

Turning now to FIG. 1, the first chamber 110 or tank is provided for receiving the material to be deposited. Typically, the first chamber 110 is provided such that the material to be evaporated in the deposition arrangement 100, i.e. an alkali or alkaline earth metal, e.g. lithium, can be provided in the first chamber 110 under a non-reactive atmosphere. For example, the non-reactive atmosphere can be argon or another inert gas suitable to prevent reaction of the material to be evaporated, which is typically highly reactive. In some embodiments, the first chamber 110 is configured to heat the material to a temperature above the melting point, for example 5°C to 100°C, for example 20°C to 60°C (e.g. 20°C or 40°C) above the melting point of the material to be deposited.

The material to be deposited is transported towards the evaporation zone 114 configured for vaporizing the liquefied material. Transport takes place via the line 120, which provides the fluid communication between the first chamber 110 and the evaporation zone 114 for the liquefied material. The line 120 includes a first portion defining a flow resistance of the line 120. Particularly, the first portion may define a flow resistance for the liquefied material to assist in controlling the flow rate of the liquefied material through the line 120. In typical embodiments, the first portion is configured to define a flow resistance for a particular liquefied material, e.g. lithium, having a defined temperature and/or viscosity. In typical embodiments, the first portion has a cross-sectional area that cannot be modified, particularly not during operation of the depositing arrangement. Thus, the flow rate may be defined by a cross section of the first portion, and no valves or other moveable or adjustable devices are used in the line 120 to define or control the flow rate of the liquefied material through the line 120.

In typical embodiments, which could be combined with other embodiments described herein, the first portion includes an aperture or orifice (see, e.g., reference numeral "121" in FIG. 2). As an example, the first portion may include or be a reduction in a diameter of the line 120. By providing the first portion, e.g. the orifice, an adjustment or (pre)definition of the flow rate of the liquefied material through the line 120, particularly in dependence on the gas pressure in the first chamber 110, can be achieved.

In typical embodiments, the first portion includes or is an orifice having a minimum diameter of 0.01 to 0.5 mm, 0.01 to 0.1 mm, and particularly 0.05 mm. As an example, the line 120 has a diameter of 1 to 10 mm, 2 to 6 mm, and particularly 4 mm, and the orifice has the minimum diameter of 0.01 to 0.5 mm, 0.01 to 0.1 mm, and particularly 0.05 mm. In typical implementations, the line 120 has a diameter of 4 mm, and the orifice has a minimum diameter of 0.05 mm. According to some embodiments, the orifice is a step in the diameter of the line 120 (e.g., a neck) or is formed by a continuous decreasing diameter of the line 120, e.g., over a section of said line 120.

According to some embodiments, which can be combined with other embodiments described herein, the first portion includes or is a capillary tube. In typical embodiments, the first portion, e.g. the capillary tube, has a diameter of 1 to 5 mm, 2 to 4 mm, and particularly 2 mm. As an example, the line 120 has a diameter of 1 to 10 mm, 2 to 8 mm, and particularly 6 mm, and the first portion has the minimum diameter of 1 to 5 mm, 2 to 4 mm, and particularly 2 mm. In typical implementations, the line 120 has a diameter of 6 mm, and the first portion has a diameter of 4 mm. In some embodiments, the line 120 is a capillary tube. As an example, the line 120, and particularly the whole line, extending from the first chamber 110 to the evaporation zone 114 is a capillary tube. Thereby, a flow resistance for the liquefied material can be defined to assist in controlling the flow rate of the liquefied material through the line 120.

According to some embodiments, which can be combined with other embodiments described herein, the line 120 or conduit can be configured to be heated such that the liquid alkali or alkaline earth metal can be provided to the evaporation zone 114, e.g. in or close to the showerhead.

According to some embodiments, vaporizing of the liquefied material in the evaporation zone 114 is assisted by a heating unit 118 provided at or near said evaporation zone 114. The one or more outlets 116, e.g., nozzles, are configured for directing the vaporized material towards the substrate 4. According to the embodiments vapor distribution showerhead 112 includes the one or more outlets 116. In typical embodiments, the vapor distribution showerhead 112 is a linear vapor distribution showerhead.

As shown in FIG. 1, the liquid material is guided in the material feed system from the first chamber 110 through the line 120 or conduit to the evaporation zone 114. A heating unit 118 can be provided, e.g., adjacent to the vapor distribution showerhead 112, to heat the material to higher temperatures before providing the liquid material in the evaporation zone 114. The material is evaporated in the evaporation zone 114. The material is distributed in the vapor distribution showerhead 112 and directed through the one or more outlets 116 towards the substrate 4.

According to some embodiments, which can be combined with other embodiments described herein, the first chamber 110 comprises the gas inlet 130 configured for an inlet of the gas in the first chamber 110. The gas can be the above-mentioned gas providing the non-reactive atmosphere in the first chamber 110, particularly argon or another inert gas suitable to prevent reaction of the material to be evaporated, which is typically highly reactive.

In the embodiments the valve 140 is configured for controlling a flow rate of the gas in the first chamber 110 for controlling a flow rate of the liquefied material through the line 120 having the flow resistance. Thus, in typical embodiments, a control of the flow rate of the liquefied material through the line 120 and thereby, the deposition rate of the vaporized material on the substrate 4 is realized by providing or applying a controlled gas (e.g., Argon) pressure in the first chamber 110. As explained above, in typical embodiments the flow rate control may further be assisted by the defined flow resistance of the line 120. Thereby, an even more accurate control of the flow rate of the liquefied material through the line 120 and thereby, deposition rate of the vaporized material on the substrate 4 is provided.

FIG. 2 shows a schematic view of another depositing arrangement for evaporation of alkali metals or alkaline earth metals, such as lithium, according to further embodiments described herein. The depositing arrangement of FIG. 2 is similar to the arrangement described above with reference to FIG. 1, wherein further elements or components are provided, which will be described below.

According to some embodiments, the deposition arrangement 100 includes a controller 150 connected to the valve 140, wherein the controller 150 is configured to control the valve 140 for adjusting the flow rate of the gas into the first chamber 110. By controlling the flow rate of the gas in the first chamber 110, the gas pressure in the first chamber 110 and thereby, a flow rate of the liquefied material through the line 120 can be controlled. In typical embodiments, the controller 150 is configured to adjust the flow rate of the gas in the first chamber 110 for a control of the deposition rate of the vapor on the substrate 4. This allows for a control of the deposition rate of the vaporized material on the substrate 4 without the need for a mechanically working valve provided in the fluid connection between the first chamber 110 and the evaporation zone 114.

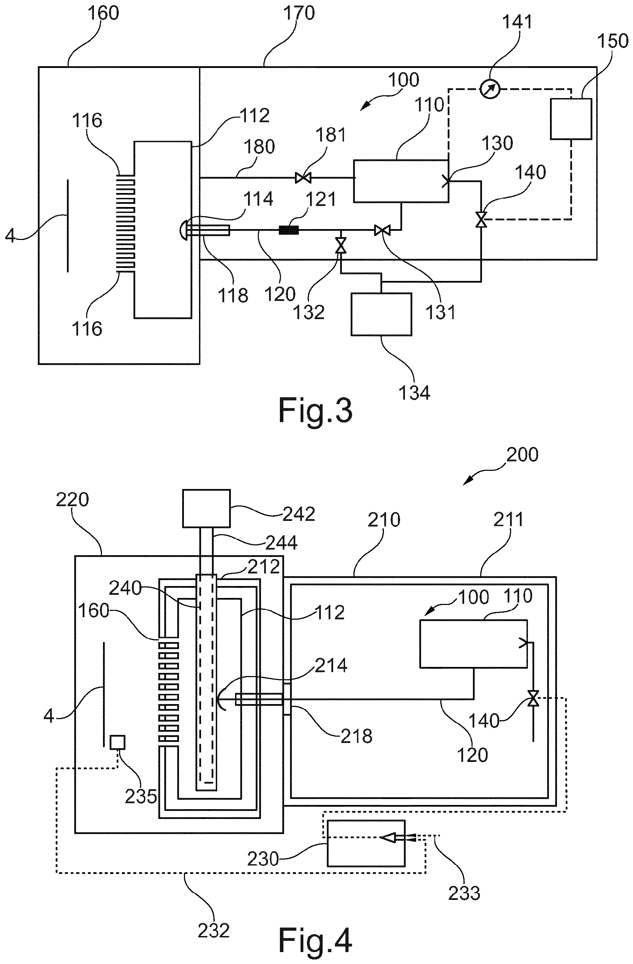

In typical embodiments, which could be combined with other embodiments disclosed herein, a signal corresponding to a measurement result of a deposition rate (e.g., measured by a deposition rate monitor system as shown in FIG. 4) could be fed to the controller 150, wherein the controller 150 could then control the valve 140 based on the signal received from the deposition rate measurement device. For example, a proportional-integral-derivative controller (PID controller) can be used. The PID controller may receive the signal via a signal line and may optionally further receive and/or store a nominal layer thickness value or another value correlating to a desired deposition rate. Thus, according to some embodiments, which can be combined with other embodiments described herein, a feedback controller is provided for controlling the valve 140. Thereby, a closed loop control of the flow rate of the gas into the first chamber 110 can be provided. Accordingly, simplified control of the deposition rate and/or of the deposition uniformity can be provided.

According to some embodiments, which could be combined with other embodiments described herein, the first chamber 110 further has a pressure gauge 141, which may be in communication with the controller 150. In typical embodiments, a gas flow through the valve 140 may be controlled or adjusted to obtain a defined pressure (measured, e.g., by the pressure gauge 141) and thereby, a defined deposition rate of the vaporized material on the substrate 4. In typical embodiments, the gas pressure in the first chamber is in the range of 1 to 1500 mbar, and particularly in the range of 400 to 600 mbar.

In typical embodiments, which could be combined with other embodiments described herein, the line 120 includes the first portion defining the flow resistance of the line 120. Particularly, the first portion may define the flow resistance for the liquefied material to assist in controlling of the flow rate of the liquefied material through the line 120. In typical embodiments, the first portion is configured to define a flow resistance for a particular liquefied material, e.g. lithium, having a defined temperature and/or viscosity.

In typical embodiments, which could be combined with other embodiments described herein, the first portion includes an orifice 121. As an example, the orifice 121 may include or be a reduction in a diameter of the line 120. By providing the orifice 121, an adjustment or (pre)definition of the flow rate of the liquefied material through the line 120, particularly in dependence on the gas pressure in the first chamber 110, can be achieved. In typical embodiments, the orifice 121 has a minimum diameter of 0.01 to 0.5 mm, 0.01 to 0.1 mm, and particularly 0.05 mm. As an example, the line 120 has a diameter of 1 to 10 mm, 2 to 6 mm, and particularly 4 mm, and the orifice 121 has the minimum diameter of 0.01 to 0.5 mm, 0.1 to 0.1 mm, and particularly 0.05 mm. According to some embodiments, the orifice 121 is formed by a step in the diameter of the line 120 (e.g., a neck) or is formed by a continuous decreasing diameter of the line 120, e.g., over a section of said line 120.

According to some embodiments, which can be combined with other embodiments described herein, the first portion includes or is a capillary tube. In typical embodiments, the first portion, e.g. the capillary tube, has a diameter of 1 to 5 mm, 2 to 4 mm, and particularly 2 mm. As an example, the line 120 has a diameter of 1 to 10 mm, 2 to 8 mm, and particularly 6 mm, and the first portion has the diameter of 1 to 5 mm, 2 to 4 mm, and particularly 2 mm. In some embodiments, the line 120 is a capillary tube. As an example, the line 120, and particularly the whole line, extending from the first chamber 110 to the evaporation zone 114 is a capillary tube. Thereby, a flow resistance for the liquefied material can be defined to assist in controlling of the flow rate of the liquefied material through the line 120.

According to some embodiments, the depositing arrangement 100 further includes a gas supply 134, such as a storage vessel or gas tank. The gas supply 134 is configured for supplying the gas, such as argon, to the first chamber 110 via the valve 140. In typical embodiments, which could be combined with other embodiments described herein, the gas supply 134 is further connected to the line 120. Thereby, the line 120 can be blown out with the gas, e.g., to remove liquid material from the line 120 that has remained there for instance after completion of a deposition process. In typical embodiments, another valve 132 is provided to close the connection between the gas supply 134 and the line 120, e.g., when liquid material is flowing through said line 120

According to some embodiments, a further valve 131 is provided in the line 120 between a connection point of the gas supply 134 with the line 120 and the first chamber 110. Thereby, a blow out of the line 120 can be performed for the portion of the line 120 between the connection point and the evaporation zone 114. Thus, the line 120 may be cleaned without having to remove the (liquid) material from the first chamber 110, since the first chamber 110 can be shut off by said further valve 131.

According to methods of operating the depositing arrangement, the gas supply 134 can include a source of hot argon. Thereby, for example in case of clogging of a portion of the material feed system, the material feed system can be flushed with hot argon. For example, the argon can be heated by guided argon tubes around the tank with liquid lithium. Further, during setting-up of operation, the material feed system can be purged with argon to avoid having oxygen and/or moisture in the system before lithium or another alkali-metal is provided in the material feed system.

In light of the above, and according to some embodiments, which can be combined with other embodiments described herein, the first chamber 110 or tank or a respective chamber for feeding the material to be evaporated into the arrangement, apparatus or system can be replaceable and/or re-fillable. Typically, it can be replaceable and/or re-filled while the material to be evaporated is under a protective atmosphere such as argon, another inert gas, and/or under vacuum conditions.

According to yet further embodiments, which can be combined with other embodiments described herein, the first chamber 110 can be a closed chamber. Typically, the closed chamber can be provided with a lid configured for opening the chamber. Material to be melted and evaporated can be re-filled when the lid is open. The closed chamber having the lid should be essentially gas tight, so that a defined gas pressure within the chamber can be maintained.

As described herein, the material feed system includes the portion of the deposition arrangement in which the liquid materials is fed towards the evaporation zone. Typically, the material feed system can include a first chamber, the line and the valve. Yet, further it can include one or more purge gas conduits and/or elements to control the temperature of the material feed system.

According to typical implementations, which can be combined with other embodiments described herein, the evaporation zone 114 can be a chamber, a crucible, a boat, or a surface, configured to provide the energy for evaporation. Typically, the zone or surface has a sufficient surface contact area, e.g. in the range of 1 cm² to 50 cm², for example 1 cm² to 10 cm², to provide sufficient energy to evaporate the material. Thereby, the surface area can be provided by a fin-structure where on or more fins protrude from a base, by a cup-like like shape, or by a spoon-like shape.

According to some implementations, the showerhead 112 as understood herein may include an enclosure having openings such that the pressure in the showerhead is higher than outside of the showerhead, for example at least one order of magnitude.

As described above, FIGs. 1 and 2 show schematic cross-sectional views of evaporation arrangements, wherein a tank is connected to the evaporation showerhead or vapor distribution showerhead 112 via the line 120. The material, e.g. lithium, is liquefied in the tank, is guided in liquid form through the line 120 defining a flow resistance for the liquefied material and is evaporated to be guided via the outlets 116, e.g. the nozzles, towards the substrate 4. The flow rate of the liquefied material through the line 120 is controlled by controlling the gas flow of the gas into the first chamber 110, and may further be controlled by the line 120 having the defined flow resistance.

According to some embodiments, the substrate or substrates can be processed vertically, i.e. the linear gas distribution showerhead is arranged vertically within a chamber and a substrate positioner holds the substrate 4 in a vertical processing position, as exemplarily shown in FIGs. 1 and 2. One advantage of this arrangement is that any particles created during processing will fall towards the bottom of a chamber and not contaminate the substrate 4.

However, the vapor distribution showerhead 112 could be oriented arbitrarily, such that depositing arrangements according to embodiments described herein can be more flexibly used as compared to other deposition sources. For example, top down evaporation can be used, e.g. in semiconductor processing, bottom up evaporation can be used, e.g. for flexible substrates, or any other orientation can be used. This flexibility in directionality in deposition comes from having an independent reservoir and deposition zone.

Although the vapor distribution showerhead 112 shown in FIGs. 1 and 2 is a linear showerhead, other shapes of showerheads are also within the scope of the disclosure. What shape the showerhead 112 should have will depend on both, the type of chamber and the shape of the substrate. For example, a point source, i.e. a single nozzle, or a circular showerhead may be selected for a chamber that processes circular substrates, such as when processing semiconductor wafers. Whereas a rectangular showerhead may be selected for processing large rectangular substrates, batch processes may also make those types of showerhead shapes more preferable. For continuous inline processing of large size rectangular or square substrates, a linear showerhead may be selected to better control the distribution of process gases over the substrate as the substrate passes by the showerhead. With respect to point source nozzles it should, however, be considered that challenges may result from managing multiple point sources to achieve uniform deposition on large area substrates. Accordingly, beneficially linear vapor distribution showerheads can be used, particularly for in-line or dynamic processing apparatus. Circular, rectangular or two or more linear vapor distribution showerheads can be used for static deposition processes of substrates of various shape and size.

The embodiments described herein can be utilized for evaporation on large area substrates, e.g. for electrochromic windows or lithium battery manufacturing. According to some embodiments, large area substrates or respective carriers, wherein the carriers have one or more substrates, may have a size of at least 0.67 m². Typically, the size can be about 0.67m² (0.73x0.92m - Gen 4.5) to about 8 m², more typically about 2 m² to about 9 m² or even up to 12 m². Typically, the substrates or carriers, for which the structures and methods according to embodiments described herein are provided, are large area substrates as described herein. For instance, a large area substrate or carrier can be GEN 4.5, which corresponds to about 0.67 m² substrates (0.73x0.92m), GEN 5, which corresponds to about 1.4 m² substrates (1.1 m x 1.3 m), GEN 7.5, which corresponds to about 4.29 m² substrates (1.95 m x 2.2 m), GEN 8.5, which corresponds to about 5.7m² substrates (2.2 m x 2.5 m), or even GEN 10, which corresponds to about 8.7 m² substrates (2.85 m × 3.05 m). Even larger generations such as GEN 11 and GEN 12 and corresponding substrate areas can similarly be implemented.

The herein described arrangements, apparatuses, systems, methods and processes can be utilized for the coating of glass substrates. However, using them, it is also possible to coat wafers, such as silicon wafers, of e.g. 200 mm or 300 mm diameter. For example, a substrate carrier can be equipped with one or with several wafers. The length of the vapor distribution showerhead, e.g. a vaporizer tube, can be adjusted to achieve the uniform coating on a large area substrate, having a substrate height of h, or of all substrates placed in a carrier. Yet further, flexible substrates of synthetic material or metal can also be processed with embodiments described herein. According to typical implementations, a substrate positioner, a substrate support or a substrate transport system can be provided and configured to position and/or move the substrate in and through a procession region.

Embodiments described herein provide an improved alkali metal, e.g. lithium, deposition system and source technology for creating thin and uniform films at high deposition rates and with reduced manufacturing cost. The deposition sources, arrangements, apparatuses, systems and methods can be applied in many fields that require uniform deposition of alkali metals, such as Li. This can be electrochemical devices which use lithium as the charge carrying element. Examples of such electrochemical devices include electrochromic windows and devices and thin film solid state batteries. Embodiments described herein significantly reduce the cost and manufacturability of existing solutions for depositing alkali metals, e.g. lithium metal.

FIG. 3 shows a schematic view of another depositing arrangement for evaporation of alkali metals or alkaline earth metals, such as lithium, according to further embodiments described herein. The depositing arrangement of FIG. 3 is similar to the arrangements described above with reference to FIGs. 1 and 2, wherein further elements or components are provided, which will be described below. Although a depositing arrangement similar to the one of FIG. 2 is shown in FIG. 3, it is to be understood that a depositing arrangement similar to the one of FIG. 1 could be used.

As shown in FIG. 3, the one or more outlets 116 and the substrate 4 are provided within a vacuum chamber 160. The one or more outlets 116 may be part of the showerhead 122, which could at least partially be provided within the vacuum chamber 160. In typical embodiments the vacuum chamber 160 is configured to provide a vacuum in the range of 10⁻² to 10⁻⁷ mbar, and particularly in the range of 10⁻⁵ to 10⁻⁶ mbar.

As further shown in FIG. 3, at least the first chamber 110 and the line 120 are provided within a heated enclosure 170, such as an atmospheric heated box. The heated enclosure 170 may have atmospheric pressure inside. For example, the heated enclosure 170 can be insulated. Thereby, a temperature-controlled environment can be provided for the first chamber 110 as well as the line 120. According to typical embodiments, the temperature can be controlled to be from 185°C to 285°C, e.g. about 230°C or 200°C. For alkali metals or alkaline earth metals other than lithium, other temperatures could be provided and adjusted according to the melting point, e.g. to 63°C or above for potassium. According to typical embodiments, which can be combined with other embodiments described herein, the temperature for liquefying the materials can be provided from 5°C to 100°C, e.g. 50°C above the melting point of the material to be deposited on the substrate 4.

According to some embodiments, which could be combined with other embodiments described herein, the depositing arrangement 100 further includes a connection between the vacuum chamber 160 and the first chamber 110. The connection may include a line 180 and a valve 181, which may be an adjustable valve. The valve 181 may be configured to close or shut off the line 180 and thereby, close or shut of the connection between the first chamber 110 and the vacuum chamber 160. Thereby, the first chamber 110 could be evacuated via the vacuum chamber 160. In other implementations, a separate pump could be used for evacuating the first chamber 110.

FIG. 4 shows a schematic cross-sectional view of a deposition apparatus 200 with a depositing arrangement 100. In typical embodiments, the depositing arrangement 100 can be one of the depositing arrangements described above with reference to FIGs. 1 and 2.

According to some embodiments, a deposition apparatus for evaporation of a material comprising an alkali metal or alkaline earth metal and for deposition of the material on a substrate is provided. The apparatus includes a vacuum chamber for depositing the material on the substrate, and a depositing arrangement as described above.

The first chamber 110 or tank, into which the material to be evaporated, e.g. lithium, is provided in an enclosure 210. For example, the enclosure 210 can be insulated. Thereby, a temperature controlled environment can be provided for the first chamber 110 as well as the line 120. According to typical embodiments, the temperature can be controlled to be from 185°C to 285°C, e.g. about 230°C or 200°C. For alkali metals or alkaline earth metals other than lithium, other temperatures could be provided and adjusted according to the melting point, e.g. to 63°C or above for potassium. According to typical embodiments, which can be combined with other embodiments described herein, the temperature for liquefying the materials can be provided from 5°C to 100°C, e.g. 50°C above the melting point of the material to be deposited on the substrate 4.

Upon heating of the material feed system including the tank and the line 120 to or above the melting point of the respective alkali metal, the metal is melted or liquefied and flows through the line 120 having the defined flow resistance in a liquid form. Although in FIG. 4 the valve 140 is provided inside the enclosure 210, in other embodiments the valve 140 could be provided outside said enclosure 210. According to typical embodiments, one or more of the elements in the enclosure 210 can be individually heated and/or the interior of the enclosure 210 can be heated as a whole. Typically, insulation as indicated by the wall 211 can be provided to reduce loss of heating energy. Additionally or alternatively, individual elements in the enclosure 210 can be insulated separately (not shown).

According to typical embodiments, which can be combined with other embodiments described herein, the material feed system and particularly the valve 140 and the line 120 are configured to provide an essentially controlled or constant flow rate of the liquid lithium. Particularly, the line 120 comprises the first portion described above with reference to FIGs. 1 and 2.

According to typical implementations, the first portion is a capillary tube having a diameter sufficiently small to result in an essentially constant flow rate towards the evaporation zone. Thereby, for example, the line 120 can have a diameter of 1 mm² to 10 mm². The diameter and desired flow rate can thereby also depend on the size of the vapor distribution showerhead 112 and the respective processing zone, such that depositing arrangements for larger substrate may have larger line diameters as compared to depositing arrangements for smaller substrates.

In light of the fact that the amount of material in the comparable thin lines or conduits is limited and that the temperatures in the liquid material feed system and that the evaporation zone can be maintained for interruption of the deposition process, the deposition arrangement 100 can be easily and fast switched on and off.

According to yet further embodiments, which can be combined with other embodiments described herein, a showerhead, particularly for large area substrates or large area carriers, can be provided with one or more material feed systems. Thereby, a depositing arrangement having a first chamber, a line, a valve, and an evaporation zone according to embodiments described herein can be provided for each of the one or more material feed systems. Each material feed system can be provided at a desired position of the vapor distribution showerhead for providing the vapor of the material in the vapor distribution showerhead. For example, two or more material feed systems can be provided to feed the same material into the vapor distribution showerhead in order to increase the deposition rate. Yet further, it is also possible to feed more than one kind of material in the vapor distribution showerhead in order to deposit a compound of the different materials provided in the different material feed systems.

As shown in FIG. 4 and according to some embodiments described herein, a vacuum feed-through 218 is provided for the line 120 to feed the metal, e.g. the liquid metal, into a vacuum chamber 220. The vacuum chamber 220 may accommodate at least the vapor distribution showerhead 112 and the substrate 4. The vacuum feed-through 218 can provide for thermal insulation between the lower temperatures in the enclosure 210 and the higher evaporation zone temperatures and/or for vacuum separation between the enclosure 210 and vacuum chamber 220. The vacuum chamber 220 is configured for depositing the metal on the substrate 4.

As shown in FIG. 4, the vapor distribution showerhead 112 is heated to vaporize the liquid lithium as indicated by evaporation zone 214. The liquid material is guided into the vapor distribution showerhead 112. The vapor distribution showerhead 112 is heated by a heating unit, e.g. an inner heating tube 240. For example, the inner heating tube 240 can be an electric heating element, which is connected by connections 244 to power supply 242. FIG. 4 further shows an insulator 212 of the vapor distribution showerhead 112. The insulation results in the reduction of heating power and/or more uniform heating of the vapor distribution showerhead 112. According to additional or alternative modifications thereof, the heating of the vapor distribution showerhead 112 can be provided by radiation heating, by heating lamps, e.g. IR heaters, inductive heating, electrical heating and combinations thereof.

The outlets 116, e.g. nozzles, provided at the vapor distribution showerhead 112 guide or direct the vapor of lithium towards the substrate 4. According to typical embodiments, the outlets 116 or nozzles can also be provided as openings in the vapor distribution showerhead 112. Further, for a linear vapor distribution showerhead, the arrangement of openings or nozzles can be for example one or more lines of openings or nozzles. For rectangular vapor distribution showerheads, the openings or nozzles can be distributed along and within a rectangular shape. For round vapor distribution showerheads, the openings or nozzles can be distributed along and within a circular shape. Typically, the openings or nozzles can be distributed such that the deposition of the vapor on the substrate 4 is uniform. Thereby, the openings or nozzles can be at least partly uniformly distributed along one of the above-described shapes. However, in order to compensate for edge effects at the perimeter of the shape, the density of openings or nozzles 160 can be varied in some regions of the vapor distribution showerhead 112.

According to some embodiments and as shown in FIG. 4, a deposition rate measurement device 235 can be provided in the vacuum chamber 220. Thereby, the deposition rate of the lithium or another alkali metal on the substrate 4 can be monitored. According to typical embodiments, one or more oscillating crystals can be utilized for thickness measurement. Additionally or alternatively, optical measurement methods within the vapor distribution showerhead 112 or at further measurement sections or openings of the vapor distribution showerhead 112 can be utilized to determine the deposition rate. According to yet further additional or alternative options, a pressure measurement inside the vapor distribution showerhead 112, a thickness measurement of the layer deposited on the substrate 4, e.g. a conductivity measurement such as an Eddy current measurement of the layer, can be conducted to determine the deposition rate. The signal relating to the deposition rate can be utilized for control of the valve 140 as described above with reference to FIG. 2.

As shown by signal line 232 in FIG. 4, a signal corresponding to the measurement result of the deposition rate measurement device 235 can be fed to the controller 230, which controls the valve 140 depending on the signal received from the deposition rate measurement device 235. The controller may be similar to the controller described above with reference to FIG. 2. For example, a proportional-integral-derivative controller (PID controller) can be used. The PID controller receives the signal via signal line 232 and may further receive and/or store a nominal layer thickness value or another value correlating to a desired deposition rate. Thus, according to some embodiments, which can be combined with other embodiments described herein, a feedback controller is provided for controlling the valve 140. Thereby, a closed loop control of the flow rate of the gas into the first chamber 110 and thereby, the flow rate of the liquid material flowing through the line 120 can be provided. Accordingly, simplified control of the deposition rate and/or of the deposition uniformity can be provided.

According to typical embodiments, which can be combined with other embodiments described herein, the valve 140 can be a control valve, i.e. a valve to control the flow rate of the gas through the valve. For example, the control valve can be configured to control the flow rate with a precision of ± 50 g/h or below, such as ± 0.1 g/h to 5 g/h.

According to embodiments described herein, the control of the deposition rate is simplified and more stable. Due the control of the flow rate of liquid material through the line by adjusting a flow rate of gas into the first chamber and thereby the gas pressure in the first chamber, there is no more need to control the deposition by a mechanically working valve in the line providing the fluid connection between the first chamber and the evaporation zone for the liquefied material. In other words, no mechanically working valve is required that is subject to corrosion or blocking, e.g., due to the high reactivity of lithium.

According to typical embodiments, which can be combined with other embodiments described herein, the depositing arrangement for evaporation of alkali or alkaline earth metals, typically, metallic lithium, apparatuses including such depositing arrangements, and methods of operating thereof can be utilized for processes where metallic lithium deposition (or other alkali metals) is desired. For example, this can be electrochemical devices, such as electrochromic windows and thin film batteries, lithium deposition during OLED device fabrication, etc.

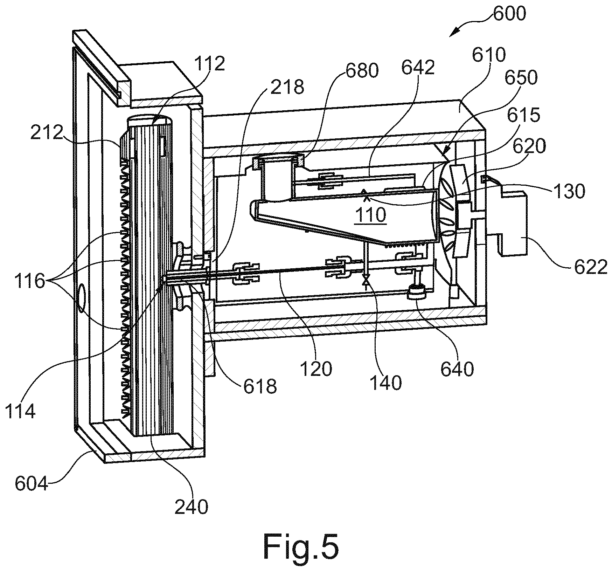

FIG. 5 shows a schematic cross-sectional view of portions of a deposition apparatus 600 with a depositing arrangement. The depositing arrangement may be similar to the depositing arrangements shown in FIGs. 1 to 3. The first chamber 100 or tank, in which the material to be evaporated, e.g. lithium, is provided, is positioned in an enclosure 650, which in turn is, according to some embodiments, positioned inside a housing 610. For example, the enclosure 650 can be insulated. Thereby, a temperature-controlled environment can be provided for at least the first chamber 110 and the line 120. According to typical embodiments, the temperature can be controlled to be from 185°C to 250°C, e.g. about 200°C. For alkali metals or alkaline earth metals other than lithium, other temperatures could be provided and adjusted according to the melting point, e.g. to 63°C or above for potassium. According to typical embodiments, which can be combined with other embodiments described herein, the temperature for liquefying the materials can be provided from 5°C to 100°C above the melting point of the material to be deposited on the substrate.

As shown in FIG. 5, the first chamber 110 has a flange 680, which can be exposed by an opening in the enclosure 650. The flange 680 allows for refilling of material in the first chamber 110. According to typical embodiments, the procedure of refilling can be provided under a protective atmosphere, e.g. an argon atmosphere.

According to typical embodiments, which can be combined with other embodiments described herein, the first chamber 110 can be provided entirely or partly with a heating system 615 to melt the material in the heated portion of the first chamber 110. The first chamber 110 is in fluid communication with the vapor distribution showerhead 112. The fluid communication is provided by the line 120. Downstream of the line 120, the vapor distribution showerhead 112 is provided. According to yet further embodiments, heating of the first chamber 110, can also be provided, as described above, by the heating of the enclosure 650.

Upon heating of the enclosure 650, at least the first chamber 110 or tank and the line 120 are heated to the melting point of the respective alkali metal, the metal is melted or liquefied and flows through the line 120 in a liquid form. According to typical embodiments, additionally, a gas circulation unit such as fan 620 is provided, which can be controlled by controller 622. For example, the controller 622 can be provided outside of the housing 610. The fan 620 allows for gas circulation inside the enclosure 650. Thereby, a uniform atmosphere can be provided inside the enclosure 650.

According to typical embodiments, which can be combined with other embodiments described herein, the enclosure 650 is at atmospheric pressure and at a temperature slightly above the melting point of the material to be evaporated, e.g. 200°C. According to one implementation, the gas in the enclosure 650 can be air, as the reactive material is inside the material feed and regulation system, which is under a protective atmosphere as described above. According to yet further implementation, a protective gas, such as argon, can also be provided in the enclosure 650 to even better avoid contact of reactive gases with the material to be melted.

According to yet further embodiments, which can be combined with other embodiments described herein, the material feed system including the first chamber 110, the line 120 having the flow resistance and the valve 140 can further include a purge valve 640 and a purge conduit 642. The purge conduit 642 and, thus, the purge valve 640 is connected with e.g. the portion of the flange 680 facing the first chamber 110. The purge conduit 642 can additionally or alternatively be provided at the first chamber 110 or at the line 120. For example, the line 120 can be connected to the purge conduit 642, similar to the blow out arrangement shown in FIG. 2 and described above. The purge conduit 642 can, according to yet further modifications, also be provided as a purge conduit arrangement with a plurality of purge conduits connected to the material feed system. However, typically, the purge conduit 642 is provided at least at an upstream end of the material feed system. According to methods of operating the deposition arrangement, the purge conduit 642 or purge valve can be connected with a source of hot argon. Thereby, for example in case of clogging of a portion of the material feed system, the material feed system can be flushed with hot argon. For example, the argon can be heated by guided argon tubes around the tank with liquid lithium. Further, during setting-up of operation, the material feed system can be purged with argon to avoid having oxygen and/or moisture in the system before lithium or another alkali-metal is provided in the material feed system.

As shown in FIG. 5, valve 140 is connected to tank via gas inlet 130. As shown in FIG. 5 and according to some embodiments described herein, a vacuum feed-through 218 is provided for the line 120 to feed the metal, e.g. the liquid metal, into the chamber portion housing the vapor distribution showerhead 112. According to typical implementations, which can be optionally be provided, the conduit portion downstream of the feed-through from the enclosure 650 to the chamber portion housing the vapor distribution showerhead 112 is heated by heating unit 618. Thereby, the portions of the deposition arrangement downstream of the enclosure 650 can be heated to higher temperatures as compared to the portions of the deposition arrangement disposed in the enclosure 650.

The chamber portion housing the vapor distribution showerhead 112 can be connected to a vacuum chamber via flange 604. As also shown in FIG. 5, adjacent or in the vapor distribution showerhead 112 an evaporation surface is heated to vaporize the liquid lithium as indicated by evaporation zone 114. The material evaporated in the evaporation zone 114 is guided into and/or distributed in the vapor distribution showerhead 112.

According to typical implementations, which can be combined with other embodiments described herein, the evaporation zone 114 can be a chamber, crucible, boat, or surface, configured to provide the energy for evaporation. Typically, the zone or surface has a sufficient surface contact area, e.g. in the range of 1 cm² to 10 cm², to provide sufficient energy to evaporate the material. Thereby, the liquid material is continuously fed into the zone or on the surface and is evaporated when it hits the surface. The heating unit 618, which is mentioned above, can be configured to continuously increase the temperature of the liquid material towards the evaporation zone 114.

The vapor distribution showerhead 112 is heated by a heating unit, e.g., an inner heating tube 240, wherein further details, aspects, features and additional or alternative implementation of a heating unit are described in other embodiments described herein. Typically, the vapor distribution showerhead 112 is provided with an insulator 212 for thermal insulation of the vapor distribution showerhead 112. The outlets 116, e.g. nozzles, provided at the vapor distribution showerhead 112 guide or direct the vapor of e.g. lithium towards a substrate. According to typical embodiments, the outlets 116 or nozzles can be provided as described with respect to other embodiments referred to herein.

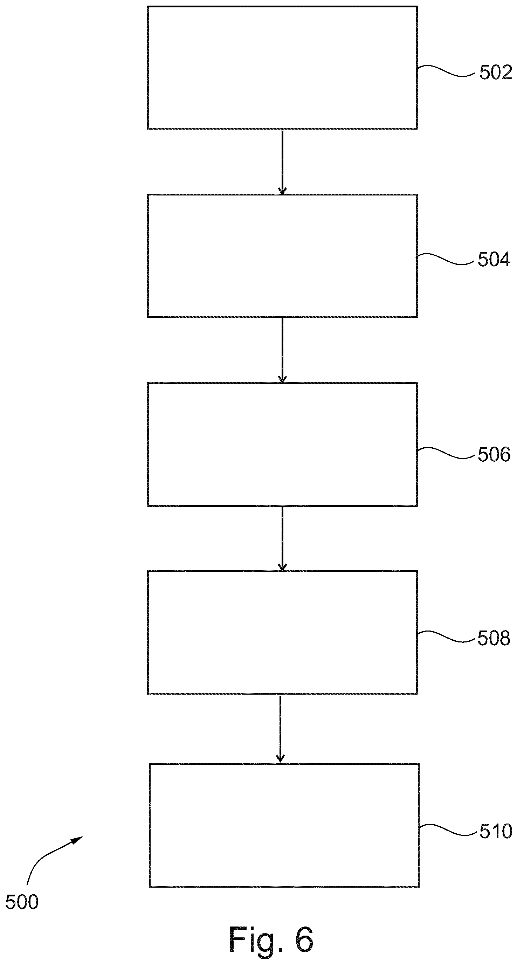

FIG. 6 shows a flow chart illustrating embodiments of methods 500 of evaporating a material comprising an alkali metal or alkaline earth metal, particularly metallic lithium. The method 500 includes liquefying the material in a first chamber as indicated by reference numeral "502". In step 504, the liquefied material is guided from the first chamber through a line to an evaporation zone, wherein the line includes a first portion defining a flow resistance of the line. In step 506, a flow rate of a gas in the first chamber is controlled for controlling a flow rate of the liquefied material through the line having the flow resistance. The material is evaporated in the evaporation zone in step 508 and the vapor of the material is directed onto a substrate in step 510.

According to typical embodiments, the step 506 (evaporation step) can be provided by flash evaporation particularly at temperatures of 600°C or above. For example, the temperature can be 800°C or above. Yet, before step 506, i.e. in step 502 and 504, the liquefied material is maintained at a temperature of 5°C to 30°C, to 60°C or 100°C above the melting point of the material to be deposited, e.g. 190°C to 290°C for metallic lithium.

According to yet further embodiments, which can be combined with other embodiments described herein, a closed loop control, for control of the valve for adjusting the flow rate of the liquefied material through the line, can be provided. The closed loop control of the valve can be simplified as compared to common lithium evaporators as merely a flow rate of gas through the valve needs to be controlled. The signal for feedback control can thereby be selected from the group consisting of: a deposition rate monitor in a vacuum chamber for vapor deposition, a flow meter such as a mass flow controller, in the system for guiding the liquefied material to the second chamber, a layer thickness measurement, such as an Eddy current measurement, a vapor pressure measurement in the showerhead, and combinations thereof.

According to embodiments described herein, the control of deposition rate is simplified and more stable. Due to the control of the flow rate of gas through the valve and by providing the line having the defined flow resistance, there is no more need to provide a mechanically working valve in the fluid connection between the first chamber and the evaporation zone.

In light of the above, the hardware requirement for embodiments described herein will also be reduced, specifically since no mechanically working valve that is resistant to highly reactive materials such as lithium needs to be provided. The deposition rate control is realized by applying a defined, controlled gas (e.g., Argon) pressure in the container where the lithium is molten, and may be assisted by a defined flow resistance provided by the line connecting the first chamber with the evaporation zone.

While the foregoing is directed to embodiments of the disclosure, other and further embodiments of the disclosure may be devised without departing from the basic scope thereof, and the scope thereof is determined by the claims that follow.

## Claims

1. A depositing arrangement (100) for evaporation of a material comprising an alkali metal or alkaline earth metal and for deposition of the material on a substrate (4), comprising:
a first chamber (110) configured for liquefying the material, wherein the first chamber (110) comprises a gas inlet (130) configured for inlet of a gas in the first chamber (110),
an evaporation zone (114) configured for vaporizing the liquefied material;
a line (120) providing a fluid communication between the first chamber (110) and the evaporation zone (114) for the liquefied material, wherein the line (120) includes a first portion defining a flow resistance of the line (120); ;
a valve (140) configured for controlling a flow rate of the gas in the first chamber (110) for controlling a flow rate of the liquefied material through the line (120) having said flow resistance; the flow rate of the liquefied material controls a deposition rate of the vaporized material on the substrate; and
one or more outlets (116) for directing the vaporized material towards the substrate (4); and
a vapor distribution showerhead (112) comprising the one or more outlets (116).

2. The arrangement (100) according to claim 1, wherein the first portion has a cross-sectional area that cannot be modified, particularly not during operation of the depositing arrangement (100).

3. The arrangement (100) according to claim 1 or 2, further comprising:
a controller (150) connected to the valve (140), wherein the controller (150) is configured to control the valve (140) for adjusting the flow rate of the gas in the first chamber (110).

4. The arrangement (100) according to claim 1 or 2, further comprising:
a controller (150) connected to the valve (140), wherein the controller (150) is configured to adjust the flow rate of the gas in the first chamber (110) for controlling of the deposition rate of the vapor on the substrate (4).

5. The arrangement (100) according to claim 3 or 4, wherein the controller (150) is a proportional-integral-derivative controller.

6. The arrangement (100) according to any of claims 3 to 5, wherein the controller comprises a signal input configured for receiving a signal of a deposition rate monitor system.

7. The arrangement (100) according to any of claims 1 to 6, wherein the first chamber (110) further comprises a pressure gauge (141).

8. The arrangement (100) according to any of claims 1 to 7, wherein the first portion comprises an orifice.

9. The arrangement (100) according to claim 8, wherein the orifice has a minimum diameter of 0.01 to 0.5 mm, 0.01 to 0.1 mm, and particularly 0.05 mm.

10. The arrangement (100) according to any of claims 1 to 9, wherein the gas is argon.

11. The arrangement (100) according to any of claims 1 to 10, wherein the vapor distribution showerhead (112) is a linear vapor distribution showerhead.

12. The arrangement (100) according to any of claims 1 to 11, further comprising:
an enclosure (170) for housing at least the first chamber (110) and the valve (140), wherein the enclosure (170) is configured for exchange of the first chamber (110) under protective atmosphere.

13. A deposition apparatus for evaporation of a material comprising an alkali metal or alkaline earth metal and for deposition of the material on a substrate, the apparatus comprising:
a vacuum chamber (160) for depositing the material on the substrate (4); and
an arrangement (100) according to any of claims 1 to 12.

14. A method of evaporating a material comprising an alkali metal or alkaline earth metal, comprising:
liquefying the material in a first chamber (110);
guiding the liquefied material from the first chamber (110) through a line (120) to an evaporation zone (114), wherein the line (120) includes a first portion defining a flow resistance of the line (120);
controlling a flow rate of a gas in the first chamber (110) for controlling a flow rate of the liquefied material through the line (120) having said flow resistance to control a deposition rate of the material to be evaporated on a substrate;
evaporating the material in the evaporation zone (114); and
directing the vapor of the material on the substrate (4) through one or more outlets of a vapor distribution showerhead (112).

15. The method according to claim 14, further comprising:
a closed loop control for control of the valve (140) for adjusting the flow rate of the liquefied material through the line (120).

## Patentansprüche

1. Abscheidungsanordnung (100) zum Verdampfen eines Materials, das ein Alkalimetall oder Erdalkalimetall umfasst, und zum Abscheiden des Materials auf einem Substrat (4), umfassend:
eine erste Kammer (110), die zum Verflüssigen des Materials konfiguriert ist, wobei die erste Kammer (110) einen Gaseinlass (130) umfasst, der zum Einlass eines Gases in die erste Kammer (110) konfiguriert ist,
eine Verdampfungszone (114), die zum Verdampfen des verflüssigten Materials konfiguriert ist;
eine Leitung (120), die eine Fluidverbindung zwischen der ersten Kammer (110) und der Verdampfungszone (114) für das verflüssigte Material bereitstellt, wobei die Leitung (120) einen ersten Abschnitt aufweist, der einen Strömungswiderstand der Leitung (120) definiert;
ein Ventil (140), das zum Steuern einer Strömungsrate des Gases in der ersten Kammer (110) zum Steuern einer Strömungsrate des verflüssigten Materials durch die Leitung (120), die den Strömungswiderstand aufweist, konfiguriert ist; wobei die Strömungsrate des verflüssigten Materials eine Abscheidungsrate des verdampften Materials auf dem Substrat steuert; und
einen oder mehrere Auslässe (116) zum Richten des verdampften Materials auf das Substrat (4); und
einen Dampfverteilungs-Showerhead (112), der den einen oder die mehreren Auslässe (116) umfasst.

2. Anordnung (100) nach Anspruch 1, wobei der erste Abschnitt eine Querschnittsfläche aufweist, die nicht verändert werden kann, insbesondere nicht während des Betriebs der Abscheidungsanordnung (100).

3. Anordnung (100) nach Anspruch 1 oder 2, ferner umfassend:
eine Steuerung (150), die mit dem Ventil (140) verbunden ist, wobei die Steuerung (150) zum Steuern des Ventils (140) zum Einstellen der Strömungsrate des Gases in der ersten Kammer (110) konfiguriert ist.

4. Anordnung (100) nach Anspruch 1 oder 2, ferner umfassend:
eine Steuerung (150), die mit dem Ventil (140) verbunden ist, wobei die Steuerung (150) zum Einstellen der Strömungsrate des Gases in der ersten Kammer (110) zum Steuern der Abscheidungsrate des Dampfes auf dem Substrat (4) konfiguriert ist.

5. Anordnung (100) nach Anspruch 3 oder 4, wobei die Steuerung (150) eine Proportional-Integral-Derivativ-Steuerung ist.

6. Anordnung (100) nach einem der Ansprüche 3 bis 5, wobei die Steuerung einen Signaleingang umfasst, der zum Empfangen eines Signals eines Abscheideratenüberwachungssystems konfiguriert ist.

7. Anordnung (100) nach einem der Ansprüche 1 bis 6, wobei die erste Kammer (110) ferner ein Druckmessgerät (141) umfasst.

8. Anordnung (100) nach einem der Ansprüche 1 bis 7, wobei der erste Abschnitt eine Öffnung umfasst.

9. Anordnung (100) nach Anspruch 8, wobei die Öffnung einen Mindestdurchmesser von 0,01 bis 0,5 mm, 0,01 bis 0,1 mm und insbesondere 0,05 mm aufweist.

10. Anordnung (100) nach einem der Ansprüche 1 bis 9, wobei das Gas Argon ist.

11. Anordnung (100) nach einem der Ansprüche 1 bis 10, wobei der Dampfverteilungs-Showerhead (112) ein linearer Dampfverteilungs-Showerhead ist.

12. Anordnung (100) nach einem der Ansprüche 1 bis 11, ferner umfassend:
ein Gehäuse (170) zum Aufnehmen mindestens der ersten Kammer (110) und des Ventils (140), wobei das Gehäuse (170) zum Austausch der ersten Kammer (110) unter Schutzatmosphäre konfiguriert ist.

13. Abscheidungsvorrichtung zum Verdampfen eines Materials, das ein Alkalimetall oder Erdalkalimetall umfasst, und zum Abscheiden des Materials auf einem Substrat, wobei die Vorrichtung umfasst:
eine Vakuumkammer (160) zum Abscheiden des Materials auf dem Substrat (4); und
eine Anordnung (100) nach einem der Ansprüche 1 bis 12.

14. Verfahren zum Verdampfen eines Materials, das ein Alkalimetall oder Erdalkalimetall umfasst, umfassend:
Verflüssigen des Materials in einer ersten Kammer (110);
Leiten des verflüssigten Materials von der ersten Kammer (110) durch eine Leitung (120) zu einer Verdampfungszone (114), wobei die Leitung (120) einen ersten Abschnitt aufweist, der einen Strömungswiderstand der Leitung (120) definiert;
Steuern einer Strömungsrate eines Gases in der ersten Kammer (110) zum Steuern einer Strömungsrate des verflüssigten Materials durch die Leitung (120), die den Strömungswiderstand aufweist, um eine Abscheidungsrate des Materials, das auf ein Substrat verdampft werden soll, zu steuern;
Verdampfen des Materials in der Verdampfungszone (114); und
Richten des Dampfes des Materials auf das Substrat (4) durch einen oder mehrere Auslässe eines Dampfverteilungs-Showerheads (112).

15. Verfahren nach Anspruch 14, ferner umfassend:
einen geschlossenen Regelkreis zum Steuern des Ventils (140) zum Einstellen der Strömungsrate des verflüssigten Materials durch die Leitung (120).

## Revendications

1. Agencement de dépôt (100) pour l'évaporation d'une matière comprenant un métal alcalin ou un métal alcalinoterreux et pour le dépôt de la matière sur un substrat (4), comprenant :
une première chambre (110) configurée pour liquéfier la matière, dans lequel la première chambre (110) comprend une entrée de gaz (130) configurée pour l'entrée d'un gaz dans la première chambre (110),
une zone d'évaporation (114) configurée pour vaporiser la matière liquéfiée ;
une conduite (120) fournissant une communication fluidique entre la première chambre (110) et la zone d'évaporation (114) pour la matière liquéfiée, dans lequel la conduite (120) comporte une première portion définissant une résistance à l'écoulement de la conduite (120) ;
une vanne (140) configurée pour commander une vitesse d'écoulement du gaz dans la première chambre (110) pour commander une vitesse d'écoulement de la matière liquéfiée à travers la conduite (120) ayant ladite résistance à l'écoulement ; la vitesse d'écoulement de la matière liquéfiée commande une vitesse de dépôt de la matière vaporisée sur le substrat ; et
une ou plusieurs sorties (116) pour orienter la matière vaporisée vers le substrat (4) ; et
une douchette de distribution de vapeur (112) comprenant les une ou plusieurs sorties (116).

2. Agencement (100) selon la revendication 1, dans lequel la première portion a une zone en coupe transversale qui ne peut pas être modifiée, en particulier pas pendant le fonctionnement de l'agencement de dépôt (100).

3. Agencement (100) selon la revendication 1 ou 2, comprenant en outre :
un dispositif de commande (150) connecté à la vanne (140), dans lequel le dispositif de commande (150) est configuré pour commander la vanne (140) pour ajuster la vitesse d'écoulement du gaz dans la première chambre (110) .

4. Agencement (100) selon la revendication 1 ou 2, comprenant en outre :
un dispositif de commande (150) connecté à la vanne (140), dans lequel le dispositif de commande (150) est configuré pour ajuster la vitesse d'écoulement du gaz dans la première chambre (110) pour commander la vitesse de dépôt de la vapeur sur le substrat (4).

5. Agencement (100) selon la revendication 3 ou 4, dans lequel le dispositif de commande (150) est un régulateur proportionnel intégral dérivé.

6. Agencement (100) selon l'une des revendications 3 à 5, dans lequel le dispositif de commande comprend une entrée de signal configurée pour recevoir un signal d'un système de surveillance de vitesse de dépôt.

7. Agencement (100) selon l'une des revendications 1 à 6, dans lequel la première chambre (110) comprend en outre une jauge de pression (141).

8. Agencement (100) selon l'une des revendications 1 à 7, dans lequel la première portion comprend un orifice.

9. Agencement (100) selon la revendication 8, dans lequel l'orifice a un diamètre minimal de 0,01 à 0,5 mm, 0,01 à 0,1 mm, et en particulier 0,05 mm.

10. Agencement (100) selon l'une des revendications 1 à 9, dans lequel le gaz est de l'argon.

11. Agencement (100) selon l'une des revendications 1 à 10, dans lequel la douchette de distribution de vapeur (112) est une douchette de distribution de vapeur linéaire.

12. Agencement (100) selon l'une des revendications 1 à 11, comprenant en outre :
une enceinte (170) pour loger au moins la première chambre (110) et la vanne (140), dans lequel l'enceinte (170) est configurée pour un échange de la première chambre (110) sous atmosphère protectrice.

13. Appareil de dépôt pour l'évaporation d'une matière comprenant un métal alcalin ou un métal alcalinoterreux et pour le dépôt de la matière sur un substrat, l'appareil comprenant :
une chambre sous-vide (160) pour déposer la matière sur le substrat (4) ; et
un agencement (100) selon l'une des revendications 1 à 12.

14. Procédé d'évaporation d'une matière comprenant un métal alcalin ou un métal alcalinoterreux, comprenant :
liquéfier la matière dans une première chambre (110) ;
guider la matière liquéfiée depuis la première chambre (110) à travers une conduite (120) jusqu'à une zone d'évaporation (114), dans lequel la conduite (120) comporte une première portion définissant une résistance à l'écoulement de la conduite (120) ;
commander une vitesse d'écoulement d'un gaz dans la première chambre (110) pour commander une vitesse d'écoulement de la matière liquéfiée à travers la conduite (120) ayant ladite résistance à l'écoulement afin de commander une vitesse de dépôt de la matière à évaporer sur un substrat ;
faire évaporer la matière dans la zone d'évaporation (114) ; et
orienter la vapeur de la matière sur le substrat (4) à travers une ou plusieurs sorties d'une douchette de distribution de vapeur (112).

15. Procédé selon la revendication 14, comprenant en outre :
une commande en boucle fermée pour la commande de la vanne (140) pour ajuster la vitesse d'écoulement de la matière liquéfiée à travers la conduite (120).
